# EUROPEAN PATENT APPLICATION

(11) **EP 4 502 091 A1**
(43) Date of publication of application: **05.02.2025**
(21) Application number: 23779532.3
(22) Date of filing: 13.03.2023
(51) Int. Cl.: C09G 1/02, B24B 37/00, C09K 3/14, H01L 21/304

(54) **POLISHING COMPOSITION**

(30) Priority: 30.03.2022 JP 2022056781
(71) Applicant: Fujimi Incorporated, Kiyosu-shi, Aichi 452-8502 (JP)
(72) Inventor: NAKAGAI, Yuichiro, Kiyosu-shi, Aichi 452-8502 (JP)
(74) Representative: Grünecker Patent- und Rechtsanwälte PartG mbB
(86) International application number: PCT/JP2023/009728
(87) International publication number: WO 2023/189512

(57) **Abstract**

Provided is a polishing composition capable of realizing high polishing removal rate on an object to be polished. The polishing composition provided by this invention is used for polishing an object to be polished. The polishing composition includes water, sodium permanganate as an oxidant, and a transition metal salt different from the oxidant. The polishing composition includes the oxidant in an amount of more than 10 wt%. In some preferable embodiments, the transition metal salt is an oxo-transition metal salt, or a multi-nuclear transition metal complex including a transition metal and one or both of oxygen and hydrogen. The polishing composition can be preferably used in polishing an object formed of a high-harness material having a Vickers hardness of 1500 Hv or higher.

## Description

### [Technical Field]

The present invention relates to a polishing composition. The present application claims priority to Japanese Patent Application No. 2022-056781 filed on March 30, 2022; and the entire content thereof is herein incorporated by reference.

### [Background Art]

Surfaces of materials such as metals, metalloids, nonmetals and their oxides are polished, using a polishing composition. For instance, a surface formed of a compound semiconductor material such as silicon carbide, boron carbide, tungsten carbide, silicon nitride, titanium nitride or gallium nitride is processed by polishing (lapping) with a diamond abrasive supplied between the surface and the polishing platen. However, diamond abrasive lapping is likely to cause and leave scratches and dents, leading to the occurrence of defects and distortions. Accordingly, studies are underway for polishing using a polishing pad and a polishing composition after or instead of diamond abrasive lapping. Publications disclosing this type of conventional art include Patent Document 1.

### [Citation List]

### [Patent Literature]

[Patent Document 1] International Publication WO2016/072370

### [Summary of Invention]

In general, in view of manufacturing efficiency and cost effectiveness, for practical use, it is desirable to have a sufficiently high polishing removal rate. For instance, in polishing a surface formed of a high-hardness material such as silicon carbide, it is strongly desired to increase the polishing removal rate. In polishing substrates formed of such high-hardness materials, to increase the polishing removal rate, it is effective to chemically alter and soften the surface to be polished in addition to using an abrasive which polishes physically. For such an effect, the polishing composition may include an oxidant. For instance, Patent Document 1 proposes a polishing composition that contains an abrasive, water and an oxidant such as potassium permanganate, and is used for polishing substrates formed of high-hardness materials.

In polishing various kinds of objects including high-hardness material substrates such as those described above, it would be practically meaningful to obtain a higher polishing removal rate. In order to further increase the polishing removal rate, it is considered effective to increase the concentration of the oxidant in the polishing composition. However, oxidants such as potassium permanganate conventionally used in this field tend not to be highly soluble in water, and it was not easy to obtain a polishing composition containing an oxidant at a high concentration.

The present invention has been made in view of such circumstances with an objective to provide a polishing composition capable of realizing high polishing removal rate for an object to be polished.

The present inventors have noted that sodium permanganate has a higher solubility in water than other permanganates conventionally used in this field, and have found that when sodium permanganate is used as the oxidant, the amount of oxidant in the polishing composition can be favorably increased.

The polishing composition provided by this description contains water, sodium permanganate as an oxidant, a transition metal salt different from the oxidant, with the oxidant content accounting for more than 10 wt% (% by weight). Such a polishing composition can stably increase the polishing removal rate while reducing its performance fluctuations (e.g., decrease in polishing removal rate, etc.) during polishing.

In some embodiments, the transition metal salt is an oxo-transition metal salt, or a multi-nuclear transition metal complex including a transition metal and one or both of oxygen and hydrogen. The use of the metal salt helps reduce pH fluctuations of the polishing composition while polishing the object.

In some embodiments, the polishing composition further contains an abrasive. The use of the abrasive can further increase the polishing removal rate.

In some embodiments, the polishing composition has a pH of 1.0 or higher and below 6.0. In this pH range, the polishing composition disclosed herein is likely to exhibit a high polishing removal rate.

For instance, the polishing composition disclosed herein is used for polishing a material having a Vickers hardness of 1500 Hv or higher. In polishing such a high-hard material, the effect of the art disclosed herein can be preferably obtained. In some embodiments, the material with Vickers hardness ≥ 1500 Hv is a non-oxide (i.e., a compound that is not an oxide). In polishing a non-oxide material, the polishing compound disclosed herein is likely to favorably increase the polishing removal rate.

The polishing composition disclosed herein is used for polishing silicon carbide, for example. In silicon carbide polishing, the effect of the art disclosed herein can be preferably obtained.

The present invention also provides a method for polishing an object to be polished. The polishing method includes a step of polishing the object, using a polishing composition disclosed herein. According to the polishing method, the polishing removal rate can be increased even when polishing an object formed of a high-hard material. This can increase the productivity of the target object (polished object, e.g., a compound semiconductor substrate such as a silicon carbide substrate) obtained through polishing by the polishing method.

The polishing composition provided by this description is a multi-agent-type polishing composition that includes Part A containing sodium permanganate as an oxidant and water, and Part B containing a transition metal salt different from the oxidant, with the oxidant content accounting for more than 10 wt%. Such a multi-agent-type polishing composition can have higher storage stability.

In some embodiments, the transition metal salt is an oxo-transition metal salt, or a multi-nuclear transition metal complex including a transition metal, oxygen and hydrogen. The use of the metal salt helps reduce pH fluctuations of the polishing composition while polishing the object.

In some embodiments, Part A or Part B contains an abrasive.

In some embodiments, the multi-agent-type polishing composition further includes Part C different from Part A and Part B, with Part C containing an abrasive.

The multi-agent-type polishing composition disclosed herein is used for polishing, for instance, a material having a Vickers hardness of 1500 Hv or higher. In polishing materials with such high hardness, the effect of the art disclosed herein can be preferably obtained. Application of this invention can bring about more favorable effects. In some embodiments, the material with 1500 Hv or higher is a non-oxide (i.e., compound that is not an oxide). In polishing non-oxide materials, the polishing composition disclosed herein is likely to favorably increase the polishing removal rate.

For instance, the multi-agent-type polishing composition disclosed herein is used for polishing silicon carbide. In silicon carbide polishing, the effect of the art disclosed herein can be preferably obtained.

This description also provides a method for polishing an object to be polished. The polishing method includes a step of polishing the object using a multi-agent-type polishing composition disclosed herein. The multi-agent-type polishing composition can be obtained, for instance, by mixing Part A and Part B as well as Part C if included. The polishing composition thus mixed is used to perform the polishing. According to this polishing method, the polishing removal rate can be increased even if the object to be polished is formed of a material with high hardness. This can increase the productivity of the target object (polished object, e.g., a compound semiconductor substrate such as a silicon carbide substrate) obtained through polishing by the polishing method.

### [Description of Embodiments]

Preferred embodiments of the present invention are described below. Matters necessary to practice this invention other than those specifically referred to in this description may be understood as design matters based on the conventional art in the pertinent field for a person of ordinary skill in the art. The present invention can be practiced based on the contents disclosed in this description and common technical knowledge in the subject field.

### <Polishing composition>

### (Oxidant)

The polishing composition disclosed herein contains an oxidant. The oxidant is effective in hardness reduction and softening of a material (e.g., a non-oxide high-hardness material such as silicon carbide) to be polished. Thus, the oxidant may increase the polishing removal rate in polishing the material to be polished. Here, the oxidant does not encompass transition metal salt C, metal salt A or metal salt B.

The polishing composition disclosed herein is characterized by containing sodium permanganate as the oxidant. Sodium permanganate tends to show high solubility in water, compared with other permanganates such as potassium permanganate. Thus, an embodiment containing sodium permanganate as the oxidant is likely to favorably increase the oxidant content of the polishing composition. The use of such sodium permanganate tends to increase the polishing removal rate.

In view of increasing the polishing removal rate, the sodium permanganate content of the polishing composition is greater than 10 wt%. In view of taking advantage of the high water-solubility of sodium permanganate to help obtain a higher polishing removal rate, in some embodiments, the sodium permanganate content can be 15 wt% or greater, 20 wt% or greater, or 22 wt% or greater. In some embodiments, the sodium permanganate content of the polishing composition is suitably about 45 wt% or less, preferably 40 wt% or less, more preferably 35 wt% or less, yet more preferably 30 wt% or less, possibly 25 wt% or less, 20 wt% or less, or 15 wt% or less. It can be advantageous to reduce the sodium permanganate content in view of reducing defects caused by sodium that may remain after polishing.

Other than sodium permanganate, the polishing composition disclosed herein may or may not contain other oxidant(s). Specific examples of compounds possibly selected as the other oxidant(s) include peroxides such as hydrogen peroxide; permanganic acid and its salts (permanganates, e.g., potassium permanganate) excluding sodium permanganate; periodic acid and its salts (periodates, e.g., sodium periodate, potassium periodate); iodic acid and its salts (iodates, e.g., ammonium iodate); bromic acid and its salts (bromates, e.g., potassium bromate); ferric acid and its salts (ferrates, e.g., potassium ferrate); perchromic acid, chromic acid and its salts (chromates, e.g., potassium chromate), dichromic acid and its salts (dichromates, e.g., potassium dichromate); vanadic acid and its salts (vanadates, e.g., ammonium vanadate, sodium vanadate, potassium vanadate); perruthenic acid and its salts (ruthenates); permolybdic acid, molybdic acid and its salts (molybdates, e.g., ammonium molybdate, disodium molybdate); perrhenic acid and its salts (thenates); pertungstic acid, tungstic acid and its salts (tungstates, e.g., disodium tungstate); persulfuric acids (e.g., peroxomonosulfuric acid, peroxodisulfuric acid) and salts thereof (e.g., ammonium persulfate, potassium persulfate); chloric acid and its salts (chlorates), perchloric acid and its salts (perchlorates, e.g., potassium perchlorate); osmium acids such as perosmic acid and osmic acid; selenium acids such as perselenic acid and selenic acid; and cerium ammonium nitrate. As the other oxidant(s), solely one kind or a combination of two or more kinds can be used among these compounds. In some embodiments, in view of stabilizing the properties of the polishing composition (e.g., preventing deterioration due to long-term storage), the other oxidant is preferably an inorganic compound.

The polishing composition disclosed herein may contain, other oxidant(s), a composite metal oxide which is a salt of a cation selected among alkali metal ions and an anion selected among transition metal oxoacid ions. The composite metal oxide is effective in hardness reduction and softening of a high-hardness material such as silicon carbide. As the composite metal oxide, solely one kind or a combination of two or more kinds can be used. Specific examples of the transition metal oxoacid ion in the composite transition metal oxide include permanganate ion, ferrate ion, chromate ion, dichromate ion, vanadate ion, ruthenate ion, molybdate ion, rhenate ion, and tungstate ion. Among these, oxoacids of 4th period transition metals of the periodic table are more preferable. Favorable examples of the transition metal in the fourth period of the periodic table include Fe, Mn, Cr, V and Ti. Among them, Fe, Mn and Cr are more preferable, with Mn being yet more preferable. The alkali metal ion in the composite transition metal oxide is preferably K⁺. In some embodiments, potassium permanganate can preferably be used as the other oxidant.

When the compound used as an oxidant is a salt (e.g., a permanganate), the compound may be present in an ionic state in the polishing composition.

### (Transition metal salt C)

The polishing composition disclosed herein contains a transition metal salt C selected among salts of anions and cations having a transition metal (i.e., a metal in groups 3 to 12 of the periodic table). As the transition metal salt C, solely one kind or a combination of two or more kinds can be used. In the polishing composition containing sodium permanganate as the oxidant, the use of the transition metal salt C can inhibit performance deterioration (e.g., decrease in polishing removal rate, etc.) of the polishing composition due to pH fluctuations of the polishing composition during polishing of the object to be polished.

In the periodic table, the transition metal is preferably a group 4-11 element, and suitably a 4th-6th period element, preferably a 4th-5th period element, or more preferably a 4th period element.

In some embodiments, the transition metal salt C is preferably a salt of an anion and a cation having a metal whose hydrated metal ion has a pKa below about 7. The transition metal salt C, which is a salt of these cation and anion, forms a hydrated metal cation (M_{aq}) in water. The hydrated metal cation acts as a pH buffer because the protons of coordinated water are in adsorption-desorption equilibrium. Thus, it is likely to inhibit performance deterioration of the polishing composition with aging. From such a viewpoint, as the transition metal salt C, it is preferable to use a salt of an anion and a cation having a metal whose hydrated metal ion has a pKa of, for instance, below 7, or 6 or lower. Examples of metal cations with M_{aq} pKa ≤ 6 include Cr³⁺ (M_{aq} pKa = 4.2), Fe³⁺ (M_{aq} pKa = 2.2), Hf⁴⁺ (M_{aq} pKa = 0.2), Zr⁴⁺ (M_{aq} pKa = -0.3), and Ti⁴⁺ (M_{aq} pKa = -4.0), but are not limited to these.

Examples of the cation forming the transition metal salt C include monoatomic transition metal cations such as Cr³⁺, Fe³⁺, Hf⁴⁺, Zr⁴⁺ and Ti⁴⁺; oxo-transition metal cations such as ZrO²⁺, ZrO⁺, HfO⁺, TiO⁺ and TiO²⁺; and transition metal hydroxide ions such as ZrOH⁺ and HfOH⁺; but are not limited to these.

The type of salt in the transition metal salt C is not particularly limited and can be an inorganic or organic salt. Examples of inorganic salts include compounds such as salts of inorganic acids such as hydrohalic acids (e.g., hydrochloric acid, hydrobromic acid, hydrofluoric acid), nitric acid, sulfuric acid, carbonic acid, silicic acid, boric acid and phosphoric acid; sulfides; oxides; oxyhalides (e.g., oxychlorides, oxybromides, oxyfluorides); inorganic oxyacid salts (e.g., oxynitrates, oxysulfates, oxycarbonates, oxysilicates, oxyborates, oxyphosphates); and oxysulfides. Examples of organic salts include salts of organic acids such as carboxylic acids (e.g., formic acid, acetic acid, propionic acid, benzoic acid, glycinic acid, butyric acid, citric acid, tartaric acid, trifluoroacetic acid), organic sulfonic acids (e.g., methanesulfonic acid, trifluoromethanesulfonic acid, benzenesulfonic acid, toluene sulfonic acid), organic phosphonic acids (e.g., methylphosphonic acid, benzenephosphonic acid, toluenephosphonic acid), and organic phosphoric acids (e.g., ethylphosphoric acid); and organic oxyacid salts such as oxyacetates. In particular, salts of hydrochloric acid, nitric acid, sulfuric acid and phosphoric acid are preferable; and salts of hydrochloric acid and nitric acid are more preferable. For instance, the art disclosed herein can be preferably implemented in an embodiment using an oxo-transition metal salt (salt of an oxo-transition metal cation and an anion) as the transition metal salt C. It can be preferably implemented in an embodiment using a salt of any oxo-transition metal cation ZrO²⁺, ZrO⁺, HfO⁺, TiO⁺ or TiO²⁺ and nitrate ion (NO₃⁻), sulfate ion (SO₄²⁻) or chloride ion (Cl⁻).

When dissolved in a solvent, the transition metal salt C forms a multi-nuclear transition metal complex including the transition metal and one or both of oxygen and hydrogen. When the transition metal salt C (e.g., zirconium nitrate, zirconium sulfate, zirconium chloride, etc.) is dissolved in water, it forms a multi-nuclear transition metal complex including zirconium and oxygen and/or hydrogen. In a preferable embodiment of the art disclosed herein, the transition metal salt C can also be a multi-nuclear transition metal complex including a transition metal, and one or both of oxygen and hydrogen produced by dissolution in a solvent. For instance, a preferable multi-nuclear transition metal complex includes zirconium and oxygen and/or hydrogen.

The transition metal salt C is preferably unsusceptible to oxidation by the oxidant. By suitably selecting the oxidant and the transition metal salt C from such a viewpoint, it is possible to prevent the oxidant from oxidizing the transition metal salt C and losing its oxidation activity, inhibiting performance deterioration (e.g., decrease in polishing removal rate) of the polishing composition with aging. From such a standpoint, examples of preferable transition metal salts C include zirconyl nitrate.

When the polishing composition contains a transition metal salt C, the transition metal salt C concentration (content) in the polishing composition is not particularly limited and can be suitably set to achieve desirable effects depending on the purpose and application of the polishing composition. The transition metal salt C can be at a concentration of, for instance, about 1000 mM or lower (i.e., 1 mol/L or lower), 500 mM or lower, or 300 mM or lower. In some embodiments, the concentration of transition metal salt C is suitably 200 mM or lower, preferably 100 mM or lower, more preferably 50 mM or lower, possibly 30 mM or lower, 20 mM or lower, or 10 mM or lower. When the polishing composition contains a transition metal salt C, the minimum concentration of transition metal salt C can be, for instance, 0.1 mM or higher. In view of suitably obtaining the use effect of transition metal salt C, it is advantageously 1 mM or higher, preferably 5 mM or higher, more preferably 10 mM or higher (e.g., 15 mM or higher), possibly 18 mM or higher, 20 mM or higher, or 30 mM or higher.

While no particular limitations are imposed, when the polishing composition contains a transition metal salt C, in view of obtaining greater effects of including the transition metal salt C in the oxidant-containing polishing composition, the transition metal salt C content CC (mM) to oxidant content Wx (wt%) ratio (CC/Wx) is typically above 0, preferably 0.01 or higher, more preferably 0.025 or higher, possibly 0.05 or higher, 0.1 or higher, or 0.5 or higher (when containing multiple transition metal salts C, CC is their total concentration; and when containing multiple oxidants, Wx is their total amount). In some embodiments, CC/Wx can be, for instance, 0.8 or higher, 1.0 or higher, 2.0 or higher, 2.5 or higher, or 3.0 or higher. The maximum CC/Wx is not particularly limited. It is generally suitably 500 or lower, possibly 300 or lower, preferably 200 or lower, more preferably 100 or lower, or yet more preferably 50 or lower. In some preferable embodiments, CC/Wx can be 25 or lower, 20 or lower, 10 or lower, 5 or lower, 4 or lower, 3 or lower, 2 or lower, or 1 or lower.

It is noted that in CC/Wx, CC is the numerical value of the transition metal salt C concentration (content) in mM in the polishing composition, and Wx is the numerical value of the oxidant content in wt% in the polishing composition, CC and Wx being both dimensionless numbers.

### (Metal salt A)

In some preferable embodiments, the polishing composition may contain a metal salt A selected among salts of anions and cations having a poor metal (i.e., a metal in the groups 13 to 16 of the periodic table). As the metal salt A, solely one kind or a combination of two or more kinds can be used. In the polishing composition containing sodium permanganate as the oxidant, the use of the metal salt A in addition can inhibit performance deterioration (e.g., decrease in polishing removal rate, etc.) of the polishing composition due to pH fluctuations of the polishing composition during polishing of the object to be polished.

In the periodic table, the poor metal is preferably a group 13-15 element, or more preferably a group 13-14 element; and preferably a 3rd-5th period element, more preferably a 3rd-4th period element, or particularly preferably the 3rd period poor metal (i.e., aluminum).

In some embodiments, the metal salt A is preferably a salt of an anion and a cation having a metal whose hydrated metal ion has a pKa below about 7. The metal salt A, which is a salt of these cation and anion, forms a hydrated metal cation (M_{aq}) in water. The hydrated metal cation acts as a pH buffer because the protons of coordinated water are in adsorption-desorption equilibrium. Thus, it is likely to inhibit performance deterioration of the polishing composition with aging. From such a viewpoint, as the metal salt A, it is preferable to use a salt of an anion and a cation having a metal whose hydrated metal ion has a pKa of, for instance, below 7, or 6 or lower. Examples of cations having a metal with M_{aq} pKa ≤ 6 include Al³⁺ (M_{aq} pKa = 5.0), Ga³⁺ (M_{aq} pKa = 2.6), and In³⁺ (M_{aq} pKa = 4.0), but are not limited to these.

The type of salt in the metal salt A is not particularly limited and can be an inorganic or organic acid salt. Examples of inorganic acid salts include salts of hydrohalic acids (e.g., hydrochloric acid, hydrobromic acid, hydrofluoric acid), nitric acid, sulfuric acid, carbonic acid, silicic acid, boric acid and phosphoric acid. Examples of organic acid salts include salts of carboxylic acids (e.g., formic acid, acetic acid, propionic acid, benzoic acid, glycinic acid, butyric acid, citric acid, tartaric acid, trifluoroacetic acid), organic sulfonic acids (e.g., methanesulfonic acid, trifluoromethanesulfonic acid, benzenesulfonic acid, toluene sulfonic acid), organic phosphonic acids (e.g., methylphosphonic acid, benzenephosphonic acid, toluenephosphonic acid), and organic phosphoric acids (e.g., ethylphosphoric acid). In particular, salts of hydrochloric acid, nitric acid, sulfuric acid and phosphoric acid are preferable; and salts of hydrochloric acid and nitric acid are more preferable. For instance, the art disclosed herein can be preferably implemented in an embodiment using a salt of any cation Al³⁺, Ga³⁺ or In³⁺ and nitrate ion (NO₃⁻) or chloride ion (Cl⁻) as the metal salt A.

The metal salt A is preferably unsusceptible to oxidation by the oxidant. By suitably selecting the oxidant and the metal salt A from such a viewpoint, it is possible to prevent the oxidant from oxidizing the metal salt A and losing its oxidation activity, inhibiting performance deterioration (e.g., decrease in polishing removal rate) of the polishing composition with aging. From such a standpoint, examples of preferable metal salts A include aluminum nitrate and aluminum chloride. By using the metal salt A with the aforementioned transition metal salt C and undermentioned metal salt B, the polishing removal rate can be increased. In some preferable embodiments, zirconyl nitrate is used as the transition metal salt C and aluminum nitrate is used as the metal salt A.

When the polishing composition contains a metal salt A, the metal salt A concentration (content) in the polishing composition is not particularly limited and can be suitably set to achieve desirable effects depending on the purpose and application of the polishing composition. The metal salt A can be at a concentration of, for instance, about 1000 mM or lower (i.e., at or below 1 mol/L), 500 mM or lower, or 300 mM or lower. In some embodiments, the concentration of metal salt A is suitably 200 mM or lower, preferably 100 mM or lower, more preferably 50 mM or lower, possibly 30 mM or lower, 20 mM or lower, or 10 mM or lower. When the polishing composition contains a metal salt A, the minimum concentration of metal salt A can be, for instance, 0.1 mM or higher. In view of suitably bringing about the use effect of metal salt A, it is advantageously 1 mM or higher, preferably 5 mM or higher, more preferably 10 mM or higher (e.g., 15 mM or higher), possibly 18 mM or higher, 20 mM or higher, or 30 mM or higher.

While no particular limitations are imposed, when the polishing composition contains a metal salt A, in view of obtaining greater effects of including the metal salt A in the oxidant-containing polishing composition, the metal salt A content CA (mM) to oxidant content Wx (wt%) ratio (CA/Wx) is typically above 0, preferably 0.01 or higher, more preferably 0.025 or higher, possibly 0.05 or higher, 0.1 or higher, or 0.5 or higher (when containing multiple metal salts A, CA is their total concentration; and when containing multiple oxidants, Wx is their total amount). In some embodiments, CA/Wx can be, for instance, 0.8 or higher, 1.0 or higher, 2.0 or higher, 2.5 or higher, or 3.0 or higher. The maximum CA/Wx is not particularly limited. It is generally suitably 500 or lower, 300 or lower, preferably 200 or lower, more preferably 100 or lower, or yet more preferably 50 or lower. In some preferable embodiments, CA/Wx can be 25 or lower, 20 or lower, 10 or lower, 5 or lower, 4 or lower, 3 or lower, 2 or lower, or 1 or lower.

It is noted that in CA/Wx, CA is the numerical value of the metal salt A concentration (content) in mM in the polishing composition, and Wx is the numerical value of the oxidant content in wt% in the polishing composition, CA and Wx being both dimensionless numbers.

### (Metal salt B)

In some preferable embodiments, the polishing composition may contain a metal salt B selected among alkaline earth metal salts. As the metal salt B, solely one kind of alkaline earth metal salt can be used alone, or two or more kinds of alkaline earth metal salts can be used in combination. The use of the metal salt B helps increase the polishing removal rate. The metal salt B preferably includes one, two or more kinds of elements among Mg, Ca, Sr and Ba as the alkaline earth metal element. Among them, it is preferably Ca or Sr, Ca being more preferable.

The type of salt in the metal salt B is not particularly limited and can be an inorganic or organic acid salt. Examples of inorganic acid salts include salts of hydrohalic acids (e.g., hydrochloric acid, hydrobromic acid, hydrofluoric acid), nitric acid, sulfuric acid, carbonic acid, silicic acid, boric acid and phosphoric acid. Examples of organic acid salts include salts of carboxylic acids (e.g., formic acid, acetic acid, propionic acid, benzoic acid, glycinic acid, butyric acid, citric acid, tartaric acid, trifluoroacetic acid), organic sulfonic acids (e.g., methanesulfonic acid, trifluoromethanesulfonic acid, benzenesulfonic acid, toluene sulfonic acid), organic phosphonic acids (e.g., methylphosphonic acid, benzenephosphonic acid, toluenephosphonic acid), and organic phosphoric acids (e.g., ethylphosphoric acid). In particular, salts of hydrochloric acid, nitric acid, sulfuric acid and phosphoric acid are preferable; and salts of hydrochloric acid and nitric acid are more preferable. For instance, the art disclosed herein can be preferably implemented in an embodiment using an alkaline earth metal nitrate or chloride as the metal salt B.

Specific examples of alkaline earth metal salts as possible choices for the metal salt B include chlorides (e.g., magnesium chloride, calcium chloride, strontium chloride, barium chloride), bromides (e.g., magnesium bromide), fluorides (e.g., magnesium fluoride, calcium fluoride, strontium chloride, barium fluoride), nitrates (e.g., magnesium nitrate, calcium nitrate, strontium nitrate, barium nitrate), sulfates (e.g., magnesium sulfate, calcium sulfate, strontium sulfate, barium sulfate), carbonates (e.g., magnesium carbonate, calcium carbonate, strontium carbonate, barium carbonate), and carboxylates (e.g., calcium acetate, strontium acetate, calcium benzoate, calcium citrate).

The metal salt B is preferably a water-soluble salt. By using a water-soluble metal salt B, a good surface without many defects (e.g., scratches) can be efficiently formed.

The metal salt B is preferably unsusceptible to oxidation by the oxidant. By suitably selecting the oxidant and the metal salt B from such a viewpoint, it is possible to prevent the oxidant from oxidizing the metal salt B and losing its oxidation activity, inhibiting performance deterioration (e.g., decrease in polishing removal rate) of the polishing composition with aging. From such a standpoint, examples of preferable metal salts B include calcium nitrate.

When the polishing composition contains a metal salt B, the metal salt B concentration (content) in the polishing composition is not particularly limited and can be suitably set to achieve desirable effects depending on the purpose and application of the polishing composition. The metal salt B can be at a concentration of, for instance, about 1000 mM or lower (i.e., at or below 1 mol/L), 500 mM or lower, or 300 mM or lower. In some embodiments, the concentration of metal salt B is suitably 200 mM or lower, preferably 100 mM or lower, more preferably 50 mM or lower, possibly 30 mM or lower, 20 mM or lower, or 10 mM or lower. The minimum metal salt B content can be, for instance, 0.1 mM or higher. In view of suitably obtaining the use effect of metal salt B, it is preferably 0.5 mM or higher, more preferably 1 mM or higher, possibly 2.5 mM or higher, 5 mM or higher, 10 mM or higher, 20 mM or higher, or 30 mM or higher.

While no particular limitations are imposed, when the polishing composition contains a metal salt B, in view of obtaining greater effects of including the metal salt B in the oxidant-containing polishing composition, the metal salt B content CB (mM) to oxidant content Wx (wt%) ratio (CB/Wx) is typically above 0, preferably 0.01 or higher, more preferably 0.025 or higher, possibly 0.05 or higher, 0.1 or higher, or 0.5 or higher (when containing multiple metal salts B, CB is their total concentration; and when containing multiple oxidants, Wx is their total amount). In some embodiments, CB/Wx can be, for instance, 0.8 or higher, 1.0 or higher, 2.0 or higher, 2.5 or higher, or 3.0 or higher. The maximum CB/Wx is not particularly limited. It is, for instance, possibly 300 or lower, generally suitably 100 or lower, preferably 75 or lower, more preferably 50 or lower, or yet more preferably 25 or lower. In some preferable embodiments, CB/Wx can be 20 or lower, 10 or lower, 5 or lower, 4 or lower, 3 or lower, 2 or lower, or 1 or lower.

It is noted that in CB/Wx, CB is the numerical value of the metal salt B concentration (content) in mM in the polishing composition, and Wx is the numerical value of the oxidant content in wt% in the polishing composition, CB and Wx being both dimensionless numbers.

In some preferable embodiments, the polishing composition may contain a metal salt A and a metal salt B together. In some preferable embodiments containing a combination of metal salts A and B, the metal salts A and B have the same anion. The common anion between the metal salts A and B can be, for instance, nitrate, chloride, or phosphate. In view of obtaining greater effects, in a particularly preferable polishing composition, the metal salts A and B are both nitrates.

When the polishing composition contains a combination of metal salts A and B, the relationship between the metal salt A concentration CA (mM) and the metal salt B concentration CB (mM) is not particularly limited and can be set to suitably obtain the effect of their combined use. For instance, CA/CB can be in the range between 0.001 and 1000. In view of increasing the polishing removal rate, in some embodiments, CA/CB is suitably about 0.01 or higher, or preferably 0.05 or higher (e.g., 0.1 or higher). CA/CB is suitably about 100 or lower, preferably 50 or lower, possibly 30 or lower, or more preferably 25 or lower (e.g., 10 or lower).

### (Abrasive)

In some embodiments of the art disclosed herein, the polishing composition contains an abrasive. According to the abrasive-containing polishing composition, while the oxidant's mainly chemical polishing action, the abrasive provides mainly mechanical polishing action. This can achieve a higher polishing removal rate.

The material and properties of the abrasive are not particularly limited. For instance, the abrasive may be inorganic particles, organic particles, or inorganic/organic composite particles. Examples include an abrasive essentially formed of any of the following: oxide particles such as silica particles, alumina particles, cerium oxide particles, chromium oxide particles, titanium dioxide particles, zirconium oxide particles, magnesium oxide particles, manganese dioxide particles, zinc oxide particles, and iron oxide particles; nitride particles such as silicon nitride particles and boron nitride particles; carbide particles such as silicon carbide particles and boron carbide particles; diamond particles; and carbonates such as calcium carbonate and barium carbonate. For the abrasive, solely one kind or a combination of two or more kinds can be used. In particular, oxide particles are preferable, such as silica particles, alumina particles, cerium oxide particles, chromium oxide particles, zirconium oxide particles, manganese dioxide particles, and iron oxide particles, because they can form good surfaces. Among them, silica particles, alumina particles, zirconium oxide particles, chromium oxide particles and iron oxide particles are more preferable; silica particles and alumina particles are even more preferable; and alumina particles are particularly preferable. In an embodiment using alumina particles as the abrasive, the art disclosed herein can be applied to favorably increase the polishing removal rate.

As used herein, with respect to the composition of an abrasive, "essentially consisting of X" or being "essentially formed of X" means that the proportion (purity) of X in the abrasive is 90 % or higher by weight. The proportion of X in the abrasive is preferably 95 % or higher, more preferably 97 % or higher, or yet more preferably 98 % or higher, e.g. 99 % or higher).

The abrasive's average primary particle diameter is not particularly limited. In view of increasing the polishing removal rate, the abrasive has an average primary particle diameter of, for instance, possibly 5 nm or greater, suitably 10 nm or greater, preferably 20 nm or greater, or also possibly 30 nm or greater. In view of further increasing the polishing removal rate, in some embodiments, the abrasive can have an average primary particle diameter of 50 nm or greater, 80 nm or greater, 150 nm or greater, 250 nm or greater, or 350 nm or greater. In view of the surface quality after polishing, the abrasive has an average primary particle diameter of, for instance, possibly 5 µm or less, preferably 3 µm or less, more preferably 1 µm or less, possibly 750 nm or less, or 500 nm or less. In view of further improving the surface quality after polishing, in some embodiments, the abrasive can have an average primary particle diameter of 350 nm or less, 180 nm or less, 85 nm or less, or 50 nm or less.

In this description, the average primary particle diameter is the particle size (BET particle size) calculated from the specific surface area (BET value) measured by the BET method, and the equation, average primary particle diameter (nm) = 6000/(true density (g/cm³) × BET value (m²/g). The specific surface area can be determined using, for instance, a surface area measuring device under product name FLOW SORB II 2300 available from Micromeritics Instrument Corporation.

The abrasive can have an average secondary particle diameter of, for instance, 10 nm or greater. In view of helping to increase the polishing removal rate, it is preferably 50 nm or greater, more preferably 100 nm or greater, possibly 250 nm or greater, or 400 nm or greater. In view of obtaining a sufficient number of particles per unit weight, the abrasive's maximum average secondary particle diameter is suitably about 10 µm or less. In view of the surface quality after polishing, the average secondary particle diameter is preferably 5 µm or less, or more preferably 3 µm or less, for instance, 1 µm or less. In view of further improving the post-polishing surface quality, in some embodiments, the abrasive can have an average secondary particle diameter of 600 nm or less, 300 nm or less, 170 nm or less, or 100 nm or less.

For particles smaller than 500 nm, the abrasive's average secondary particle diameter can be determined as the volume mean particle diameter (arithmetic mean diameter by volume, Mv) by dynamic light scattering, using, for instance, model UPA-UT151 available from Nikkiso Co., Ltd.; for particles of 500 nm or larger, it can be determined as the volume mean particle diameter by pore electrical resistance, etc., using model MULTISIZER 3 available from Beckman Coulter Inc.

When using alumina particles (alumina abrasive) as the abrasive, a suitable one can be selected and used among various known kinds of alumina particles. Examples of known alumina particles include α-alumina and intermediate alumina. The intermediate alumina here is a generic term for alumina particles excluding α-alumina, with specific examples including γ-alumina, δ-alumina, θ-alumina, η-alumina, κ-alumina and χ-alumina. Alternatively, based on classifications by manufacturing method, an alumina called fumed alumina (typically alumina dust (microparticles) produced upon high-temperature calcination of an alumina salt) can be used as well. Examples of the known alumina particles further include colloidal alumina and alumina sol (e.g., alumina hydrate such as boehmite). In view of processability, α-alumina is preferably included. The alumina abrasive in the art disclosed herein may include solely one such kind of alumina particles or a combination of two or more kinds.

When using alumina particles as the abrasive, the higher the amount of alumina particles in the entire abrasive used, the more advantageous. For instance, the alumina particle content of the is preferably 70 wt% or greater, more preferably 90 wt% or greater, yet more preferably 95 wt% or greater, or essentially 100 wt%.

The particle size of the alumina abrasive is not particularly limited and can be selected to obtain desirable polishing effects. In view of increasing the polishing removal rate, the alumina abrasive has an average primary particle diameter of preferably 50 nm or greater, more preferably 80 nm or greater, possibly 150 nm or greater, 250 nm or greater, or 300 nm or greater. The maximum average primary particle diameter of the alumina abrasive is not particularly limited. In view of the surface quality after polishing, it is suitably about 5 µm or less. In view of further improving the post-polishing surface quality, it is preferably 3 µm or less, more preferably 1 µm or less, possibly 750 nm or less, 500 nm or less, 400 nm or less, or 350 nm or less.

When using alumina particles as the abrasive, the polishing composition disclosed herein may further contain an abrasive formed of a material other than alumina (or a non-alumina abrasive, hereinafter). Examples of the non-alumina abrasive include an abrasive essentially formed of any one of the following: silica particles, cerium oxide particles, chromium oxide particles, titanium dioxide particles, zirconium oxide particles, magnesium oxide particles, manganese dioxide particles, zinc oxide particles, and iron oxide particles; nitride particles such as silicon nitride particles and boron nitride particles; carbide particles such as silicon carbide particles and boron carbide particles; diamond particles; and carbonates such as calcium carbonate and barium carbonate.

The non-alumina abrasive content is, for instance, suitably 30 % by weight of the total weight of abrasive in the polishing composition or lower, preferably 20 % by weight or lower, or more preferably 10 % by weight or lower.

In another preferable embodiment of the art disclosed herein, the polishing composition contains silica particles (silica abrasive) as the abrasive. A suitable silica abrasive can be selected and used among various known kinds of silica particles. Examples of such known silica particles include colloidal silica and dry-process silica. In particular, colloidal silica is preferably used. A silica abrasive containing colloidal silica can favorably achieve good surface smoothness.

The shape (outer particle shape) of the silica abrasive may be globular or non-globular. For instance, specific examples of the non-globular silica abrasives have shapes of peanut (i.e., peanut shell), cocoon, conpeito, rugby ball, etc. In the art disclosed herein, the silica abrasive may be present as primary particles or as secondary particles which are aggregates of some primary particles. Alternatively, both primary particles and secondary particles of the silica abrasive may be present in a mixed state. In a preferable embodiment, the polishing composition contains at least part of the silica abrasive as secondary particles.

A preferable silica abrasive has an average primary particle diameter greater than 5 nm. In view of the polishing removal rate, etc., the silica abrasive has an average primary particle diameter of preferably 15 nm or greater, more preferably 20 nm or greater, yet more preferably 25 nm or greater, or particularly preferably 30 nm or greater. The average primary particle diameter of the silica abrasive is not particularly limited. It is suitably about 120 nm or less, preferably 100 nm or less, or more preferably 85 nm or less. For instance, in view of combining a polishing removal rate and surface quality at a higher level, a preferable silica abrasive has a BET diameter of 12 nm or greater and 80 nm or less, and more preferably 15 nm or greater and 75 nm or less.

The average secondary particle diameter of the silica abrasive is not particularly limited. In view of the polishing removal rate, etc., it is preferably 20 nm or greater, more preferably 50 nm or greater, or yet more preferably 70 nm or greater. In view of obtaining a surface of higher quality, the average secondary particle diameter of the silica abrasive is suitably 500 nm or less, preferably 300 nm or less, more preferably 200 nm or less, yet more preferably 130 nm or less, or particularly preferably 110 nm or less (e.g., 100 nm or less).

The silica particles have a true specific gravity (true density) of preferably 1.5 or greater, more preferably 1.6 or greater, or yet more preferably 1.7 or greater. With increasing true specific gravity of silica particles, the physical polishing ability tends to improve. The silica particle's maximum true specific gravity is not particularly limited. It is typically 2.3 or less, for instance, 2.2 or less, 2.0 or less, or 1.9 or less. The silica particle's true specific gravity can be determined by the fluid displacement method using ethanol as the displacement fluid.

The silica particles preferably have a globular shape (outer shape). While no particular limitations are imposed, the particles have a major axis/minor axis ratio (average aspect ratio) of 1.00 or greater in principle. In view of increasing the polishing removal rate, it can be, for instance, 1.05 or greater, or 1.10 or greater. The particle's average aspect ratio is suitably 3.0 or less, or possibly 2.0 or less. In view of increasing the smoothness of the polished surface and reducing damage, the particles average aspect ratio is preferably 1.50 or less, possibly 1.30 or less, or 1.20 or less.

The particle's shape (outer shape) and average aspect ratio can be obtained, for instance, by electron microscopy observations. In a specific procedure for obtaining the average aspect ratio, for instance, by scanning electron microscopy (SEM), the shapes of a prescribed number (e.g., 200) of particles are extracted. With respect to the shape of each particle extracted, the smallest circumscribed rectangle is drawn. Then, for the rectangle drawn for each particle shape, the length of the long side (major axis) is divided by the length of the short side (minor axis) to determine the major axis/minor axis ratio (aspect ratio). The average aspect ratio can be obtained by arithmetically averaging the aspect ratios of the prescribed number of particles.

In embodiments where the polishing composition contains a silica abrasive, the polishing composition may further contain an abrasive formed of a material other than silica (or a non-silica abrasive, hereinafter). Examples of particles forming such a non-silica abrasive include particles essentially formed of any kind among oxide particles such as alumina particles, cerium oxide particles, chromium oxide particles, titanium dioxide particles, zirconium oxide particles, magnesium oxide particles, manganese oxide particles, zinc oxide particles, iron oxide particles; nitride particles such as silicon nitride particles and boron nitride particles; carbide particles such as silicon carbide particles and boron carbide particles; diamond particles; carbonates such as calcium carbonate and barium carbonate; and the like.

Of the total weight of the abrasive in the polishing composition, the amount of non-silica abrasive is, for instance, suitably 30 wt% or less, preferably 20 wt% or less, or more preferably 10 wt% or less.

In view of the post-polishing surface quality, etc., the amount of abrasive (e.g., alumina abrasive, etc.) in the polishing composition disclosed herein is suitably below 10 wt%, advantageously below 6 wt%, preferably below 3 wt%, more preferably below 2 wt%, possibly below 1.5 wt%, 1.3 wt% or less, 1.2 wt% or less, 1.1 wt% or less, or 1.0 wt% or less. In some embodiments, the amount of abrasive in the polishing composition can be 0.5 wt% or less or below 0.5 wt%, 0.1 wt% or less or below 0.1 wt%, 0.05 wt% or less or below 0.05 wt%, 0.04 wt% or less or below 0.04 wt%. The minimum amount of abrasive is not particularly limited and can be, for instance, 0.000001 wt% or greater (i.e., 0.01 ppm higher). In view of enhancing the effect of the abrasive use, in some embodiments, the amount of abrasive in the polishing composition can be 0.00001 wt% or greater, 0.0001 wt% or greater, 0.001 wt% or greater, 0.002 wt% or greater, or 0.005 wt% or greater. In some embodiments, the abrasive content of the polishing composition can be 0.01 wt% or greater, 0.02 wt% or greater, 0.03 wt% or greater, above 0.1 wt%, above 0.3 wt%, 0.5 wt% or greater, or 0.8 wt% or greater. When the polishing composition disclosed herein contains multiple kinds of abrasive, the amount of abrasive therein refers to the total amount of the multiple kinds of abrasive.

The polishing composition disclosed herein is preferably essentially free of diamond particles as the particles. Diamond particles have high hardness and thus can be a limiting factor in improving smoothness. Diamond particles are also generally expensive, so they are not a cost-effective material. In practice, it can be less dependent on expensive materials such as diamond particles. Here, that the particles are essentially free of diamond particles means that, of all the particles, diamond particles account for 1 wt% or less, more preferably 0.5 wt% or less, and typically 0.1 wt% or less, including a case where diamond particles account for 0 wt%. Such an embodiment can favorably bring about the application effects of this invention.

In the abrasive-containing polishing composition, the relationship between the oxidant content and the abrasive content is not particularly limited and can be suitably set to achieve desirable effects depending on the purpose and application. The oxidant content Wx (wt%) to abrasive content Wp (wt%) ratio (i.e., Wx/Wp) is, for instance, possibly about 0.01 or higher, suitably 0.025 or higher, also possibly 0.05 or higher, 0.1 or higher, 0.2 or higher, advantageously 1 or higher, 1.4 or higher, preferably 2.5 or higher, or more preferably 3.5 or higher. With increasing Wx/Wp, chemical polishing tends to contribute more than mechanical polishing does. In some embodiments, Wx/Wp can be 5 or higher, 6 or higher, even 6.5 or higher, 7 or higher, 8 or higher, or 9 or higher. In some preferable embodiments, Wx/Wp can be, for instance, about 10 or higher, 30 or higher, 50 or higher, 70 or higher, 90 or higher, 120 or higher, 150 or higher, or 180 or higher. The maximum Wx/Wp is not particularly limited. In view of the polishing composition's storage stability, etc., it can be, for instance, about 5000 or lower, 1500 or lower, 1000 or lower, 800 or lower, 400 or lower, 250 or lower, 100 or lower, 80 or lower, or 40 or lower. In some embodiments, Wx/Wp can be 30 or lower, 20 or lower, or 10 or lower.

It is noted that in Wx/Wp, Wx is the numerical value of the oxidant content in wt% in the polishing composition, and Wp is the numerical value of the abrasive content in wt% in the polishing composition, Wx and Wp being both dimensionless numbers.

In the polishing composition containing an abrasive and a transition metal salt C, the relationship between the concentration of transition metal salt C and the abrasive content is not particularly limited and can be suitably set to achieve desirable effects depending on the purpose and application. The transition metal salt C concentration CC (mM) to abrasive content Wp (wt%) ratio (i.e., CC/Wp) is, for instance, possibly 0.05 or higher, suitably 0.1 or higher, possibly 0.2 or higher, preferably 1 or higher, more preferably 3 or higher, or also possibly 5 or higher, or 10 or higher (when containing multiple transition metal salts C, CC is their total concentration; when containing multiple abrasives, Wp is their total amount). With increasing CC/Wp, chemical polishing tends to contribute more than mechanical polishing does. In some embodiments, CC/Wp can be 12 or higher, 15 or higher, or 18 or higher. In other embodiments, CC/Wp can be 50 or higher, 100 or higher, 150 or higher, 200 or higher, or 250 or higher. The maximum CC/Wp is not particularly limited. In view of the polishing composition's storage stability, it can be, for instance, about 20000 or lower, 10000 or lower, 5000 or lower, 2500 or lower, or 1000 or lower. In some embodiments, CC/Wp can be 100 or lower, 50 or lower, 40 or lower, or 30 or lower.

It is noted that in CC/Wp, CC is the numerical value of the concentration of transition metal salt C in mM in the polishing composition, and Wp is the numerical value of the abrasive content in wt% in the polishing composition, CC and Wp being both dimensionless numbers.

In the polishing composition containing an abrasive and a metal salt A, the relationship between the concentration of metal salt A and the abrasive content is not particularly limited and can be suitably set to achieve desirable effects depending on the purpose and application. The metal salt A concentration CA (mM) to abrasive content Wp (wt%) ratio (i.e., CA/Wp) is, for instance, possibly 0.05 or higher, suitably 0.1 or higher, possibly 0.2 or higher, preferably 1 or higher, more preferably 3 or higher, or also possibly 5 or higher, or 10 or higher (when containing multiple metal salts A, CA is their total concentration; when containing multiple abrasives, Wp is their total amount). With increasing CA/Wp, chemical polishing tends to contribute more than mechanical polishing does. In some embodiments, CA/Wp can be 12 or higher, 15 or higher, or 18 or higher. The maximum CA/Wp is not particularly limited. In view of the polishing composition's storage stability, it can be, for instance, about 20000 or lower, 10000 or lower, 5000 or lower, 2500 or lower, or 1000 or lower. In some embodiments, CA/Wp can be 100 or lower, 50 or lower, 40 or lower, or 30 or lower.

It is noted that in CA/Wp, CA is the numerical value of the concentration of metal salt A in mM in the polishing composition, and Wp is the numerical value of the abrasive content in wt% in the polishing composition, CA and Wp being both dimensionless numbers.

In the polishing composition containing an abrasive and a metal salt B, the relationship between the concentration of metal salt B and the abrasive content is not particularly limited and can be suitably set to achieve desirable effects depending on the purpose and application. The metal salt B concentration CB (mM) to abrasive content Wp (wt%) ratio (i.e., CB/Wp) is, for instance, possibly 0.05 or higher, suitably 0.1 or higher, possibly 0.2 or higher, preferably 1 or higher, more preferably 3 or higher, or also possibly 5 or higher, or 10 or higher (when including multiple metal salts B, CB is their total concentration; when containing multiple abrasives, Wp is their total amount). With increasing CB/Wp, chemical polishing tends to contribute more than mechanical polishing does. In some embodiments, CB/Wp can be 20 or higher, 50 or higher, 100 or higher, or 300 or higher. The maximum CB/Wp is not particularly limited. In view of the polishing composition's storage stability, it can be, for instance, about 10000 or lower, 5000 or lower, or 2500 or lower. In some embodiments, CB/Wp can be 1000 or lower, 800 or lower, or 600 or lower.

It is noted that in CB/Wp, CB is the numerical value of the concentration of metal salt B in mM in the polishing composition, and Wp is the numerical value of the abrasive content in wt% in the polishing composition, CB and Wp being both dimensionless numbers.

The polishing composition disclosed herein can be also preferably made in an embodiment not containing an abrasive. Even in such an embodiment, the use of sodium permanganate as the oxidant will effectively increase the polishing removal rate.

### (Water)

The PSA composition disclosed herein contains water. Preferable examples of the water include ion-exchanged water (deionized water), pure water, ultrapure water and distilled water. The polishing composition disclosed herein may further contain, as necessary, an organic solvent (lower alcohol, lower ketone, etc.) that can mix uniformly with water. In typical, the solvent in the polishing composition is suitably at least 90 vol% (% by volume) water, preferably at least 95 vol%, or more preferably 99 vol% to 100 vol% water.

### (Acid)

The polishing composition can contain an acid as necessary for adjusting pH, increasing the polishing removal rate, or like purpose. As the acid, an inorganic or organic acid can be used. Examples of inorganic acids include sulfuric acid, nitric acid, hydrochloric acid, and carbonic acid. Examples of organic acids include aliphatic carboxylic acids such as formic acid, acetic acid and propionic acid; aromatic carboxylic acids such as benzoic acid and phthalic acid; citric acid, oxalic acid, tartaric acid, malic acid, maleic acid, fumaric acid, succinic acid, organosulfonic acids, and organophosphonic acids. Among these, solely one kind or a combination of two or more kinds can be used. When using an acid, the amount is not particularly limited and can be set in accordance with the purpose of use (e.g., pH adjustment). Alternatively, in some embodiments of the polishing composition disclosed herein, the composition can be essentially free of an acid.

### (Basic compound)

The polishing composition can contain a basic compound as necessary for adjusting pH, increasing the polishing removal rate, or like purpose. Here, the basic compound refers to a compound that increases the pH of the polishing composition when added to the composition. Examples of the basic compound include alkali metal hydroxides such as potassium hydroxide and sodium hydroxide; bicarbonates and carbonates such as ammonium bicarbonate, ammonium carbonate, potassium bicarbonate, potassium carbonate, sodium bicarbonate, and sodium carbonate; ammonia; quaternary ammonium compounds such as quaternary ammonium hydroxides (e.g., tetramethylammonium hydroxide, tetraethylammonium hydroxide, tetrabutylammonium hydroxide, etc.); amines, phosphates, hydrogen phosphates, and organic acid salts. As the basic compound, solely one kind or a combination of two or more kinds can be used. When using a basic compound, the amount is not particularly limited and can be set in accordance with the purpose of use (e.g., pH adjustment). Alternatively, in some embodiments of the polishing composition disclosed herein, the composition can be essentially free of a basic compound.

### (Other Components)

As long as the effect of the present invention is not impaired, the polishing composition disclosed herein may further contain, as necessary, known additives that can be used in polishing compositions (e.g., polishing compositions used for polishing high-hardness materials such as silicon carbide), such as chelating agent, thickener, dispersing agent, surface-protecting agent, wetting agent, surfactant, anti-corrosive, antiseptic agent, and antifungal agent. The amounts of the additives can be suitably selected in accordance with their purposes and do not characterize the present invention; and therefore, details are omitted.

### (pH)

The polishing composition suitably has a pH of about 1 to 12. When the pH is in this range, a practical polishing removal rate is likely to be obtained. In some embodiments, the pH can be 12.0 or lower, 11.0 or lower, 10.0 or lower, 9.0 or lower, below 9.0, 8.0 or lower, below 8.0, 7.0 or lower, below 7.0, or 6.0 or lower. In view of further helping to obtain an increase in polishing removal rate by using the metal salt A, in some embodiments, the polishing composition has a pH of preferably below 6.0, possibly 5.0 or lower, below 5.0, 4.0 or lower, or below 4.0. The pH can be, for instance, 1.0 or higher, 1.5 or higher, 2.0 or higher, or 2.5 or higher.

The method for producing the polishing composition disclosed herein is not particularly limited. For instance, the respective components of the polishing composition may be mixed, using a known mixing device, such as a propeller stirrer, ultrasonic disperser, and homomixer. The mode of mixing these components is not particularly limited. For instance, all the components can be mixed at once or in a suitably prescribed order.

The polishing composition disclosed herein can be a single-agent type or a multi-agent type such as two-agent type. For example, it may be formulated so that Part A containing some of the components of the polishing composition and Part B containing remaining components are mixed together and used for polishing an object to be polished. The multi-agent type polishing composition may further include Part C in addition to Part A and Part B. For instance, before use, they can be stored separately and mixed at the time of use to prepare a polishing composition. When mixing them, water or the like for dilution may be further mixed in. In a preferable embodiment, the multi-agent-type polishing composition disclosed herein contains an oxidant and water in Part A, and a transition metal salt C and water in Part B. Such an embodiment can improve the storage stability of the polishing composition. Part C for optional use may or may not contain an abrasive.

### <Object to be polished>

The object to be polished with the polishing composition disclosed herein is not particularly limited. For instance, the polishing composition disclosed herein can be applied to polishing a substrate having a surface formed of a compound semiconductor material, that is, a compound semiconductor substrate. The material forming the compound semiconductor substrate is not particularly limited. Examples include II-VI group compound semiconductors such as cadmium telluride, zinc selenide, cadmium sulfide, mercury cadmium telluride, and cadmium zinc telluride; III-V group compound semiconductors such as gallium nitride, gallium arsenide, gallium phosphide, indium phosphide, aluminum gallium arsenide, gallium indium arsenide, nitrogen indium gallium arsenide, and aluminum gallium indium phosphide; and IV-IV group compound semiconductors such as silicon carbide and germanium silicide. The object to be polished may be formed of a plurality of these materials. In a preferable embodiment, the polishing composition disclosed herein can be applied to polish a substrate having a surface formed of a non-oxide compound semiconductor material. In polishing a substrate having a surface composed of a non-oxide compound semiconductor material. In polishing a substrate with a surface formed of a non-oxide compound semiconductor material, the oxidant in the polishing composition disclosed herein is likely to favorably facilitate polishing.

The polishing composition disclosed herein can be preferably used for polishing a surface having a Vickers hardness of, for instance, 500 Hv or higher. The Vickers hardness is preferably 700 Hv or higher, for instance, 1000 Hv or higher, or 1500 Hv or higher. The material to be polished can have a Vickers hardness of 1800 Hv or higher, 2000 Hv or higher, or 2200 Hv or higher. The maximum Vickers hardness of the surface of the object to be polished is not particularly limited and can be, for instance, about 7000 Hv or lower, 5000 Hv or lower, or 3000 Hv or lower. Here, Vickers hardness can be determined based on JIS R 1610:2003 corresponding to International standard ISO 14705:2000.

Examples of materials having a Vickers hardness of 1500 Hv or higher include silicon carbide, silicon nitride, titanium nitride, and gallium nitride. The object to be polished in the art disclosed herein may have a mechanically and chemically stable single-crystal surface of an aforementioned material. In particular, the surface of the object to be polished is preferably formed of either silicon carbide or gallium nitride, and more preferably formed of silicon carbide. Silicon carbide holds promise as a compound semiconductor substrate material with low power loss and excellent heat resistance. The improvement in productivity by increasing the polishing removal rate has an especially great practical advantage. The art disclosed herein can be particularly preferably applied to polishing a silicon carbide single-crystal surface.

### <Polishing Method>

The polishing composition disclosed herein can be used in polishing of an object to be polished in an embodiment including, for instance, the following operations:
In particular, a polishing slurry is obtained, including a polishing composition disclosed herein. Obtaining the polishing slurry may include preparing the polishing slurry from the polishing composition via operations such as concentration adjustment (e.g., dilution) and pH adjustment. Alternatively, the polishing composition may be used as is as the polishing slurry. When the polishing composition is separated in multiple formulas, obtaining the polishing slurry may include mixing the formulas, diluting one or more formulas before mixing them, and diluting the mixture after mixing them.

Subsequently, the polishing slurry is supplied to the object and polishing is carried out according to a typical method by a skilled person. For instance, in one method, the object is set in a general polishing machine and the polishing slurry is supplied via a polishing pad of the polishing machine to the object's surface to be polished. In typical, while the polishing slurry is continuously supplied, the polishing pad is pushed against the object's surface to be polished, and the two are moved (e.g. rotated) in coordination. Via such a polishing step, polishing of the object is completed.

As for the respective possible components in the polishing composition in the art disclosed herein, their amounts (concentrations) and ratio (concentration ratio) typically refer to those in the polishing composition at the time of supply to the object to be polished (i.e., at the point of use). Thus, they can be read as their amounts and concentration ratio in the polishing slurry.

The present description provides a method for polishing an object (typically a material) to be polished and a method for producing a polished object using the polishing method. The polishing method is characterized by including a step of polishing an object to be polished using the polishing composition disclosed herein. The polishing method according to a preferable embodiment includes a stock polishing step and a final polishing step. In a typical embodiment, the stock polishing step is arranged immediately before the final polishing step. The stock polishing step can be a single-stage polishing process or a multi-stage polishing process having two or more stages. The final polishing step performs final polishing on the stock-polished object is the last (i.e., most downstream) polishing step among the polishing steps carried out using abrasive-containing polishing slurries. In such a polishing method including stock and final polishing steps, the polishing composition disclosed herein can be used in the stock polishing step, in the final polishing step, or in both polishing steps.

The stock polishing and the final polishing can be applied to polishing with either a single-side or double-side polishing machine. With a single-side polishing machine, the object to be polished is adhered to a ceramic plate with wax or held with a holder called a carrier; and while supplying the polishing composition, a polishing pad is pushed against one face of the object and the two are moved in coordination to polish the one face of the object. The move operation can be, for instance, rotation. With a double-side polishing machine, the object to be polished is held with a holder called a carrier; and while supplying the polishing composition from the top, polishing pads are pushed against opposing faces of the object and rotated in opposite directions to simultaneously polish the two faces of the object.

The polishing conditions are suitably set based on the kind of material to be polished, target surface properties (specifically, smoothness), polishing removal rate, etc.; and thus, are not limited to specific conditions. As for the processing pressure (removal pressure), the polishing composition disclosed herein can be used in a wide pressure range, for instance, 10 kPa up to 150 kPa. In view of increasing the polishing removal rate, in some embodiments, the processing pressure can be, for instance, 5 kPa or higher, 10 kPa or higher, 20 kPa or higher, 30 kPa or higher, or 40 kPa or higher; and 100 kPa or lower, 80 kPa or lower, or 60 kPa or lower. The polishing composition disclosed herein can also be preferably used under process conditions, for instance, 30 kPa or higher, to increase the productivity of target objects (polished objects) obtained through such polishing. It is noted that the processing pressure here is synonymous with polishing pressure.

The polishing pads used in the respective polishing steps disclosed herein are not particularly limited. For instance, any kinds can be used among non-woven fabric types, suede types, and hard polyurethane foam types. In some embodiments, a hard polyurethane foam-type of polishing pad can be preferably used. It is noted that the art disclosed herein uses a polishing pad free of an abrasive.

The object to be polished by the method disclosed herein is typically cleaned after polished. The cleaning can be carried out using a suitable cleaning solution. The cleaning solution is not particularly limited. A suitable kind can be selected and used among detergents that are commonly known or used.

The polishing method disclosed herein may include an optional step in addition to the stock and final polishing steps. Examples of such steps include a mechanical polishing step and a lapping step carried out before the stock polishing step. In the mechanical polishing step, the object is polished using a dispersion of a diamond abrasive in a solvent. In some preferable embodiments, the dispersion is free of an oxidant. In the lapping step, the surface of a polishing platen, (e.g., cast iron platen), is pushed against the object. Thus, polishing pads are not used in the lapping step. The lapping step is typically carried out with an abrasive supplied between the polishing platen and the object to be polished. The abrasive is typically a diamond abrasive. The polishing method disclosed herein may include an additional step before the stock polishing step, or between the stock and final polishing steps. The additional step can be, for instance, a cleaning step or a polishing step.

### <Method for producing polished object>

The art disclosed herein may include a method for producing a polished object, the method including a polishing step by an aforementioned polishing method; and a polished object produced by the method. Examples of the polished object production method include a method for producing a silicon carbide substrate. In other words, the art disclosed herein provides a method for producing a polished object, the method including polishing an object to be polished that is formed of a high-hardness material, by applying a polishing method disclosed herein; and a polished object produced by the method. The production method can efficiently provide a substrate produced through polishing, for instance, a silicon carbide substrate.

### [Examples]

Several working examples related to the present invention are described below, but the present invention is not limited to these examples. In the description below, "%" is by weight unless otherwise informed.

### <<Experiment 1»

### <Preparation of polishing compositions>

### (Example S1)

Were mixed a silica abrasive, sodium permanganate as an oxidant, zirconyl nitrate as a transition metal salt C and deionized water to prepare a polishing composition containing 0.1 % silica abrasive, 12.0 % sodium permanganate and 30 mM of zirconyl nitrate (concentration based on Zr). In preparing the polishing composition of this example, no pH-adjusting agent was used. The polishing composition according to this example had the pH shown in Table 1.

### (Examples S2 to S4)

The concentrations of sodium permanganate were as shown in Table 1. Otherwise in the same manner as Example S1, were prepared polishing compositions of the respective examples. The polishing composition according to each example had the pH shown in Table 1.

### (Example S5)

Were mixed a silica abrasive, potassium permanganate as an oxidant, aluminum nitrate as a metal salt A and deionized water to prepare a polishing composition containing 0.1 % silica abrasive, 4.0 % potassium permanganate and 30 mM of aluminum nitrate (concentration based on Al).

### (Example S6)

Using the metal salt shown in Table 1, but otherwise in the same manner as Example S5, was prepared a polishing composition of this example. The polishing composition according to this example had the pH shown in Table 1.

### (Example S7)

Were mixed a silica abrasive, potassium permanganate as an oxidant and deionized water in an attempt to prepare a polishing composition containing 0.1 % silica abrasive and 12.0 % potassium permanganate. However, potassium permanganate did not dissolve completely when mixed in, not resulting in the polishing composition with the above composition. With respect to Example S7, "N/A (not available)" is indicated in the "Availability of composition" column of Table 1.

### (Example S8)

Using the metal salt shown in Table 1, but otherwise in the same manner as Example S1, was prepared a polishing composition of this example. The polishing composition according to this example had the pH shown in Table 1.

In the polishing compositions of Examples S1 to S8, as the silica abrasive, was used colloidal silica having an average primary particle diameter of 35 nm.

### <Polishing object to be polished>

Using a stock polishing composition containing an alumina abrasive, SiC wafers were subjected to stock polishing. With each stock-polished SiC wafer being the object to be polished, using the polishing composition according to each example as-is as the polishing slurry, the object was polished under the conditions shown below.

### [Polishing conditions]

polishing machine: model RDP-500 available from Fujikoshi Machinery Corp.
polishing pad: IC-1000 (formed of hard polyurethane) available from NITTA DuPont Inc. processing pressure: 490 gf/cm²
platen rotational speed: 130 rotations/min
head rotations: 130 rotations/min
supply rate of polishing slurry: 20 mL/min
mode of use of polishing slurry: one-way
polishing time: 5 minutes
object to be polished: 4-inch SiC wafer (conduction: n-type, crystal structure: 4H-SiC, off-angle of main surface (0001) relative to C-axis: 4°), 1 sheet/batch
temperature of polishing slurry: 23 °C

Polishing pads were used after their polishing surfaces were subjected to brush dressing for 5 minutes, diamond dressing for 3 minutes, and further brush dressing for 5 minutes. Brush dressing and diamond dressing were performed before the polishing.

### <Measurement and evaluation>

### (Polishing removal rate)

Under the polishing conditions shown above, using the polishing composition of each example, was polished a SiC wafer. Then, based on the formulas (1) and (2), was determined the polishing removal rate.
(1) Polishing removal (cm) = difference in weight of SiC wafer before and after polishing (g)/density of SiC (g/cm³) (= 3.21 g/cm³)/area to be polished (cm²) (= 78.54 cm²)
(2) Polishing removal rate (nm/h) = polishing removal (cm) × 10⁷/polishing time (= 5/60 hour)

The results were converted to relative values with the polishing removal rate for Example S5 being 100 %. The larger the value, the greater the polishing removal rate.

The resulting polishing removal rates of the respective examples are shown in the corresponding column of Table 1.

### [Table 1]

**Table 1**

| | Amount of silica abrasive (wt%) | Oxidant | | Transition metal salt C | | Metal salt A | | Availability of composition | pH | Polishing removal rate (ratio) |
|---|---|---|---|---|---|---|---|---|---|---|
| | | species | amount (wt%) | species | amount (mM) | species | amount (mM) | | | |
| Ex. S1 | 0.1 | NaMnO₄ | 12.0 | ZrO(NO₃)₂ | 30 | - | - | available | 2.5 | 146.3 |
| Ex. S2 | 0.1 | NaMnO₄ | 15.0 | ZrO(NO₃)₂ | 30 | - | - | available | 2.5 | 148.6 |
| Ex. S3 | 0.1 | NaMnO₄ | 17.5 | ZrO(NO₃)₂ | 30 | - | - | available | 2.5 | 154.4 |
| Ex. S4 | 0.1 | NaMnO₄ | 20.0 | ZrO(NO₃)₂ | 30 | - | - | available | 2.5 | 161.2 |
| Ex. S5 | 0.1 | KMnO₄ | 4.0 | - | - | Al(NO₃)₃ | 30 | available | 3.8 | 100.0 |
| Ex. S6 | 0.1 | KMnO₄ | 4.0 | ZrO(NO₃)₂ | 30 | - | - | available | 2.5 | 115.4 |
| Ex. S7 | 0.1 | KMnO₄ | 12.0 | - | - | Al(NO₃)₃ | 30 | N/A | - | - |
| Ex. S8 | 0.1 | NaMnO₄ | 12.0 | - | - | Al(NO₃)₃ | 30 | available | 3.8 | 125.9 |

The results shown in Table 1 have confirmed the tendency of the polishing removal rate to increase with increasing the amount of sodium permanganate (NaMnO₄) as the oxidant. The results have also shown that addition of a transition metal salt C to the NaMnO₄-containing polishing composition tends to further increase the polishing removal rate, compared to addition of a metal salt A that is different from the transition metal salt C. In Example S7 using 12% potassium parmanganate as the oxidant, a polishing composition was not obtained.

### <<Experiment 2>>

### <Preparation of polishing compositions>

### (Example A1)

Were mixed an alumina abrasive, sodium permanganate as an oxidant, zirconyl nitrate as a transition metal salt C and deionized water to prepare a polishing composition containing 0.1 % alumina abrasive, 12.0 % sodium permanganate and 40 mM of zirconyl nitrate (concentration based on Zr). In preparing the polishing composition of this example, no pH-adjusting agent was used. The polishing composition according to this example had the pH shown in Table 2.

### (Examples A2 to A6)

The concentrations of sodium permanganate and the concentrations of zirconyl nitrate were as shown in Table 2. Otherwise in the same manner as Example A1, were prepared polishing compositions of the respective examples.

### (Example A7)

Were mixed an alumina abrasive, potassium permanganate as an oxidant, aluminum nitrate as a metal salt A and deionized water to prepare a polishing composition containing 0.1 % alumina abrasive, 4.0 % potassium permanganate and 30 mM of aluminum nitrate (concentration based on Al). In preparing the polishing composition of this example, no pH-adjusting agent was used. The polishing composition according to this example had the pH shown in Table 2.

### (Example A8)

Using the metal salt shown in Table 2, but otherwise in the same manner as Example A7, was prepared a polishing composition of this example. The polishing composition according to this example had the pH shown in Table 2.

### (Example A9)

Were mixed an alumina abrasive, potassium permanganate as an oxidant and deionized water in an attempt to prepare a polishing composition containing 0.1 % alumina abrasive and 12.0 % potassium permanganate. However, potassium permanganate did not dissolve completely when mixed in, not resulting in the polishing composition with the above composition. With respect to Example A9, "N/A (not available)" is indicated in the "Availability of composition" column of Table 2.

### (Example A10)

Using the metal salt shown in Table 2, but otherwise in the same manner as Example A1, was prepared a polishing composition of this example. The polishing composition according to this example had the pH shown in Table 2.

In the polishing compositions of Examples A1 to A10, as the alumina abrasive, was used α-alumina abrasive having an average primary particle diameter of 310 nm.

### <Polishing object to be polished>

Using a stock polishing composition containing an alumina abrasive, SiC wafers were subjected to stock polishing. With each stock-polished SiC wafer being the object to be polished, using the polishing composition according to each example as-is as the polishing slurry, the object was polished under the conditions shown below.

### [Polishing conditions]

polishing machine: model RDP-500 available from Fujikoshi Machinery Corp.
polishing pad: IC-1000 (formed of hard polyurethane) available from NITTA DuPont Inc.
processing pressure: 490 gf/cm²
platen rotational speed: 130 rotations/min
head rotations: 130 rotations/min
supply rate of polishing slurry: 20 mL/min
mode of use of polishing slurry: one-way
polishing time: 5 minutes
object to be polished: 4-inch SiC wafer (conduction: n-type, crystal structure: 4H-SiC, off-angle of main surface (0001) relative to C-axis: 4°), 1 sheet/batch
temperature of polishing slurry: 23 °C

Polishing pads were used after their polishing surfaces were subjected to brush dressing for 5 minutes, diamond dressing for 3 minutes, and further brush dressing for 5 minutes. Brush dressing and diamond dressing were performed before the polishing.

### <Measurement and evaluation>

### (Polishing removal rate)

Under the polishing conditions shown above, using the polishing composition of each example, was polished a SiC wafer. Then, based on the formulas (1) and (2), was determined the polishing removal rate.
(1) Polishing removal (cm) = difference in weight of SiC wafer before and after polishing (g)/density of SiC (g/cm³) (= 3.21 g/cm³)/area to be polished (cm²) (= 78.54 cm²)
(2) Polishing removal rate (nm/h) = polishing removal (cm) × 10⁷/polishing time (= 5/60 hour)

The results were converted to relative values with the polishing removal rate for Example A7 being 100 %. The larger the value, the greater the polishing removal rate.

The resulting polishing removal rates of the respective examples are shown in the corresponding column of Table 2.

### [Table 2]

**Table 2**

| | Amount of alumina abrasive (wt%) | Oxidant | | Transition metal salt C | | Metal salt A | | Availability of composition | pH | Polishing removal rate (ratio) |
|---|---|---|---|---|---|---|---|---|---|---|
| | | species | amount (wt%) | species | amount (mM) | species | amount (mM) | | | |
| Ex. A1 | 0.1 | NaMnO₄ | 12.0 | ZrO(NO₃)₂ | 40 | - | - | available | 2.5 | 153.2 |
| Ex. A2 | 0.1 | NaMnO₄ | 15.0 | ZrO(NO₃)₂ | 30 | - | - | available | 2.5 | 149.8 |
| Ex. A3 | 0.1 | NaMnO₄ | 15.0 | ZrO(NO₃)₂ | 40 | - | - | available | 2.5 | 158.1 |
| Ex. A4 | 0.1 | NaMnO₄ | 15.0 | ZrO(NO₃)₂ | 60 | - | - | available | 2.5 | 146.1 |
| Ex. A5 | 0.1 | NaMnO₄ | 17.5 | ZrO(NO₃)₂ | 40 | - | - | available | 2.5 | 160.2 |
| Ex. A6 | 0.1 | NaMnO₄ | 20.0 | ZrO(NO₃)₂ | 40 | - | - | available | 2.5 | 174.3 |
| Ex. A7 | 0.1 | KMnO₄ | 4.0 | - | - | Al(NO₃)₃ | 30 | available | 3.8 | 100.0 |
| Ex. A8 | 0.1 | KMnO₄ | 4.0 | ZrO(NO₃)₂ | 40 | - | - | available | 2.5 | 121.4 |
| Ex. A9 | 0.1 | KMnO₄ | 12.0 | - | - | Al(NO₃)₃ | 30 | N/A | - | - |
| Ex. A10 | 0.1 | NaMnO₄ | 12.0 | - | - | Al(NO₃)₃ | 30 | available | 3.8 | 130.2 |

The results shown in Table 2 have confirmed the tendency of the polishing removal rate to increase with increasing the amount of NaMnO₄ as the oxidant. The results have also shown that addition of a transition metal salt C to the NaMnO₄-containing polishing composition tends to further increase the polishing removal rate, compared to addition of a metal salt A that is different from the transition metal salt C. In Example A9 using 12% potassium permanganate as the oxidant, a polishing composition was not obtained.

Although specific embodiments of the present invention have been described in detail above, these are merely for illustrations and do not limit the scope of claims. The art according to the claims includes various modifications and changes made to the specific embodiments illustrated above.

## Claims

1. A polishing composition comprising sodium permanganate as an oxidant, a transition metal salt different from the oxidant, and water,
wherein the polishing composition comprises the oxidant in an amount of more than 10 % by weight.

2. The polishing composition according to Claim 1, wherein the transition metal salt is an oxo-transition metal salt, or a multi-nuclear transition metal complex comprising a transition metal and one or both of oxygen and hydrogen.

3. The polishing composition according to Claim 1 or 2, further comprising an abrasive.

4. The polishing composition according to any one of Claims 1 to 3, having a pH of 1.0 or higher and lower than 6.0.

5. The polishing composition according to any one of Claims 1 to 4, in use for polishing a material having a Vickers hardness of 1500 Hv or higher.

6. The polishing composition according to any one of Claims 1 to 5, in use for polishing silicon carbide.

7. A polishing method comprising a step of polishing an object to be polished, using the polishing composition according to any one of Claims 1 to 6.

8. A multi-agent-type polishing composition comprising
a part A comprising water and sodium permanganate as an oxidant, and
a part B comprising water and a transition metal salt different from the oxidant,
wherein the oxidant is contained in an amount of more than 10 % by weight in the multi-agent-type polishing composition.

9. The multi-agent-type polishing composition according to Claim 8, wherein the transition metal salt is an oxo-transition metal salt, or a multi-nuclear transition metal complex comprising a transition metal, oxygen, and hydrogen.

10. The multi-agent-type polishing composition according to Claim 8 or 9, wherein the part A or the part B comprises an abrasive.

11. The multi-agent-type polishing composition according to Claim 8 or 9, further comprising a part C different from the part A and the part B, wherein the part C comprises an abrasive.

12. The multi-agent-type polishing composition according to any one of Claims 8 to 11, in use for polishing a material having a Vickers hardness of 1500 Hv or higher.

13. The multi-agent-type polishing composition according to any one of Claims 8 to 12, in use for polishing silicon carbide.

14. A polishing method comprising a step of polishing an object to be polished, using the multi-agent-type polishing composition according to any one of Claims 8 to 13.

15. The polishing method according to Claim 14, comprising mixing the part A, the part B, and a part C when the part C is included in the multi-agent-type polishing composition; and polishing the object to be polished while supplying the mixed polishing composition.
